# EUROPEAN PATENT APPLICATION

(11) **EP 4 788 070 A1**
(43) Date of publication of application: **05.08.2026**
(21) Application number: 25808895.4
(22) Date of filing: 07.04.2025
(51) Int. Cl.: H05K 5/02

(54) **WEARABLE ELECTRONIC DEVICE**

(30) Priority: 07.05.2024 CN 202410558072
(71) Applicant: HUAWEI TECHNOLOGIES CO., LTD., Shenzhen 518129 (CN)
(72) Inventor: WU, Haobo, Shenzhen, Guangdong 518129 (CN); LI, Kun, Shenzhen, Guangdong 518129 (CN); SUN, Qiao, Shenzhen, Guangdong 518129 (CN); LIU, Bing, Shenzhen, Guangdong 518129 (CN); ZOU, Lin, Shenzhen, Guangdong 518129 (CN); GAO, Jianming, Shenzhen, Guangdong 518129 (CN); LIANG, Chi, Shenzhen, Guangdong 518129 (CN)
(74) Representative: Maiwald GmbH
(86) International application number: PCT/CN2025/087515
(87) International publication number: WO 2025/232421

(57) **Abstract**

A wearable electronic device is provided, and belongs to the field of electronic device technologies. The wearable electronic device includes a housing and an antenna apparatus. The housing includes a contact surface, and the contact surface is configured to be in contact with a wearer. The antenna apparatus is disposed inside the housing, the antenna apparatus includes a first antenna structure and a second antenna structure, and both the first antenna structure and the second antenna structure are configured to generate resonance. The first antenna structure, the second antenna structure, and the contact surface are sequentially arranged in a thickness direction of the housing, and the first antenna structure and the second antenna structure are disposed at an interval. A projection of the second antenna structure at least partially overlaps a projection of the first antenna structure in the thickness direction of the housing. In this way, absorption of electromagnetic energy by a human body can be reduced, and antenna efficiency can be improved.

## Description

This application claims priority to Chinese Patent Application No. 202410558072.1, filed with the China National Intellectual Property Administration on May 7, 2024 and entitled "WEARABLE ELECTRONIC DEVICE", which is incorporated herein by reference in its entirety.

### TECHNICAL FIELD

Embodiments of this application relate to the technical field of electronic devices, and in particular, to a wearable electronic device.

### BACKGROUND

A wearable electronic device is a compact and close-fitting intelligent device. Common wearable electronic devices include a watch, a band, a headset, glasses, a pendant, and the like. The watch is used as an example. The watch integrates a communication function, and has a built-in antenna to transmit or receive an electromagnetic signal. In a related technology, the wearable electronic device includes a housing, a printed circuit board, and an antenna. The printed circuit board and the antenna are disposed inside the housing. The antenna is placed on the printed circuit board. A feed point and a ground point of the antenna are separately connected to the printed circuit board. The printed circuit board is also used as a ground plate of the antenna. However, the watch is close to a human body during usage, and an electromagnetic wave emitted by the antenna is greatly absorbed by the human body. Consequently, antenna efficiency is reduced.

### SUMMARY

Embodiments of this application provide a wearable electronic device, to reduce absorption of electromagnetic energy by a human body and improve antenna efficiency.

A first aspect of this application provides a wearable electronic device, including a housing and an antenna apparatus. The housing includes a contact surface, and the contact surface is configured to be in contact with a wearer. The antenna apparatus is disposed inside the housing, the antenna apparatus includes a first antenna structure and a second antenna structure, and both the first antenna structure and the second antenna structure are configured to generate resonance. The first antenna structure, the second antenna structure, and the contact surface are sequentially arranged in a thickness direction of the housing, and the first antenna structure and the second antenna structure are disposed at an interval. A projection of the second antenna structure at least partially overlaps a projection of the first antenna structure in the thickness direction of the housing.

During operation of the antenna apparatus, both the first antenna structure and the second antenna structure generate resonance. In this way, an electromagnetic wave can be received or transmitted. In addition, a polarization deflection apparatus configured to change electric field distribution near the wearer may be formed, so that a proportion of normal components (perpendicular to a surface of a human body) in electric field distribution near the wearer increases, thereby increasing difficulty of entering the human body by an electric field, reducing absorption of electromagnetic energy by the human body, and improving antenna efficiency. In addition, the second antenna structure may further equivalently increase an antenna clearance, and may further improve antenna performance.

In a possible implementation, the wearable electronic device includes an electrical connection structure, and the first antenna structure is electrically connected to the second antenna structure via the electrical connection structure.

In this way, absorption of electromagnetic energy by the human body can be further reduced, and antenna efficiency can be further improved. In addition, when the wearable electronic device is light and thin, it can also be ensured that antenna efficiency meets a requirement.

In a possible implementation, the antenna apparatus satisfies a relational expression: L+H=kλn. L is the length of the second antenna structure, H is the length of the electrical connection structure, λ is a wavelength corresponding to an operating frequency band of the antenna apparatus in free space, k is a positive integer, and n is greater than or equal to 1/4.

In this way, when both the first antenna structure and the second antenna structure generate the resonance, the proportion of the normal components in the electric field distribution near the wearer can be changed, thereby increasing the difficulty of the electric field entering the human body, and reducing the absorption of the electromagnetic energy by the human body. In addition, the antenna clearance may be further equivalently increased, and the antenna performance may be further improved.

In a possible implementation, H is greater than or equal to a spacing between the first antenna structure and the second antenna structure in the thickness direction of the housing.

In this way, the absorption of the electromagnetic energy by the human body is reduced, and impact of the electrical connection structure on the thickness of the wearable electronic device can be avoided, thereby helping achieve a thinning design of the wearable electronic device.

In a possible implementation, the wearable electronic device includes a floor structure, the floor structure has a first electrical connection region, the second antenna structure has a second electrical connection region, and the first electrical connection region is electrically connected to the second electrical connection region via the electrical connection structure.

In this way, the first antenna structure can be stably electrically connected to the second antenna structure via the floor structure, which helps ensure stability of operation of the antenna apparatus.

In a possible implementation, a projection of the first electrical connection region at least partially overlaps a projection of the second electrical connection region in the thickness direction of the housing.

In this way, the absorption of the electromagnetic energy by the human body can be further reduced, and the antenna efficiency can be improved.

In a possible implementation, a projection of the electrical connection structure is located within an overlapping region between the projection of the first electrical connection region and the projection of the second electrical connection region.

In this way, the absorption of the electromagnetic energy by the human body can be further reduced, and the antenna efficiency can be improved. In addition, a structure of the electrical connection structure may be further simplified.

In a possible implementation, the electrical connection structure is electrically connected to a maximum current point of the floor structure.

In this way, the absorption of the electromagnetic energy by the human body can be further reduced, and the antenna efficiency can be further improved.

In a possible implementation, the electrical connection structure is further configured to generate resonance with both the first antenna structure and the second antenna structure.

In this way, the electrical connection structure may also be configured to transmit and receive the electromagnetic wave, which helps further improve the antenna efficiency.

In a possible implementation, the floor structure is further configured to generate resonance with both the first antenna structure and the second antenna structure.

In this way, the floor structure may also be configured to transmit and receive the electromagnetic wave, which helps further improve the antenna efficiency.

In a possible implementation, the first antenna structure and the electrical connection structure are of an integrated structure.

In this way, stability of a connection between the first antenna structure and the electrical connection structure can be improved. In addition, production efficiency of the wearable electronic device can be further improved.

In a possible implementation, the second antenna structure and the electrical connection structure are of an integrated structure.

In this way, stability of a connection between the second antenna structure and the electrical connection structure can be improved. In addition, production efficiency of the wearable electronic device can be further improved.

In a possible implementation, the first antenna structure, the second antenna structure, and the electrical connection structure are of an integrated structure.

In this way, stability of connections between the electrical connection structure and the first antenna structure and between the electrical connection structure and the second antenna structure can be improved. In addition, production efficiency of the wearable electronic device can be further improved.

In a possible implementation, the projection of the second antenna structure includes the projection of the first antenna structure and a projection of the floor structure in the thickness direction of the housing.

In this way, the electric field entering the human body can be further reduced, and the absorption of the electromagnetic energy by the human body can be further reduced, thereby helping further improve the antenna efficiency.

In a possible implementation, the projection of the second antenna structure includes the projection of the first antenna structure in the thickness direction of the housing.

In this way, the electric field entering the human body can be further reduced, and the absorption of the electromagnetic energy by the human body can be further reduced, thereby helping further improve the antenna efficiency.

In a possible implementation, the second antenna structure is a closed ring structure, or the second antenna structure is a stub structure.

In a possible implementation, the first antenna structure includes a feed point, which can reduce difficulty of feeding the antenna apparatus.

In a possible implementation, the wearable electronic device includes a printed circuit board, and the printed circuit board includes the first antenna structure.

In a possible implementation, the wearable electronic device includes a circuit board assembly, the circuit board assembly includes a first circuit board and a second circuit board that are electrically connected, where the first circuit board includes the first antenna structure, and the second circuit board includes the second antenna structure.

In a possible implementation, the wearable electronic device includes a circuit board assembly, the circuit board assembly includes a first circuit board and a second circuit board that are electrically connected, the first circuit board includes the first antenna structure, and the first circuit board, the second circuit board, and the second antenna structure are sequentially arranged at an interval in the thickness direction of the housing.

In a possible implementation, the first antenna structure is one of the following antennas: an inverted F antenna, a monopole antenna, a loop antenna, and a planar inverted F antenna.

In a possible implementation, the wearable electronic device is a watch or a band.

A second aspect of this application provides an antenna assembly, where the antenna assembly includes an antenna apparatus configured to be mounted inside a housing of a wearable electronic device. The antenna apparatus includes a first antenna structure and a second antenna structure, and both the first antenna structure and the second antenna structure are configured to generate resonance. The first antenna structure, the second antenna structure, and a contact surface that is in the housing and that is used to be in contact with a wearer are sequentially arranged in a thickness direction of the housing. The first antenna structure and the second antenna structure are disposed at an interval. A projection of the second antenna structure at least partially overlaps a projection of the first antenna structure in the thickness direction of the housing.

In a possible implementation, the antenna assembly includes an electrical connection structure, and the first antenna structure is electrically connected to the second antenna structure via the electrical connection structure.

In a possible implementation, the antenna apparatus satisfies a relational expression: L+H=kλn. L is the length of the second antenna structure, H is the length of the electrical connection structure, λ is a wavelength corresponding to an operating frequency band of the antenna apparatus in free space, k is a positive integer, and n is greater than or equal to 1/4.

In a possible implementation, H is greater than or equal to a spacing between the first antenna structure and the second antenna structure in the thickness direction of the housing.

In a possible implementation, the antenna assembly includes a floor structure, the floor structure has a first electrical connection region, the second antenna structure has a second electrical connection region, and the first electrical connection region is electrically connected to the second electrical connection region via the electrical connection structure.

In a possible implementation, a projection of the first electrical connection region at least partially overlaps a projection of the second electrical connection region in the thickness direction of the housing.

In a possible implementation, a projection of the electrical connection structure is located within an overlapping region between the projection of the first electrical connection region and the projection of the second electrical connection region.

In a possible implementation, the electrical connection structure is electrically connected to a maximum current point of the floor structure.

In a possible implementation, the electrical connection structure is further configured to generate resonance with both the first antenna structure and the second antenna structure.

In a possible implementation, the first antenna structure and the electrical connection structure are of an integrated structure.

In a possible implementation, the second antenna structure and the electrical connection structure are of an integrated structure.

In a possible implementation, the first antenna structure, the second antenna structure, and the electrical connection structure are of an integrated structure.

In a possible implementation, the projection of the second antenna structure includes the projection of the first antenna structure and a projection of the floor structure in the thickness direction of the housing.

In a possible implementation, the projection of the second antenna structure includes the projection of the first antenna structure in the thickness direction of the housing.

In a possible implementation, the second antenna structure is a closed ring structure, or the second antenna structure is a stub structure.

In a possible implementation, the first antenna structure includes a feed point.

In a possible implementation, the antenna assembly includes a printed circuit board, and the printed circuit board includes the first antenna structure.

In a possible implementation, the antenna assembly includes a circuit board assembly, the circuit board assembly includes a first circuit board and a second circuit board that are electrically connected, where the first circuit board includes the first antenna structure, and the second circuit board includes the second antenna structure.

In a possible implementation, the antenna assembly includes a circuit board assembly, the circuit board assembly includes a first circuit board and a second circuit board that are electrically connected, the first circuit board includes the first antenna structure, and the first circuit board, the second circuit board, and the second antenna structure are sequentially arranged at an interval in the thickness direction of the housing.

In a possible implementation, the first antenna structure is one of the following antennas: an inverted F antenna, a monopole antenna, a loop antenna, and a planar inverted F antenna.

### BRIEF DESCRIPTION OF DRAWINGS

FIG. 1 is a schematic cross-sectional view of a wearable electronic device in an explosive state according to an embodiment of this application;
FIG. 2 is a schematic cross-sectional view of a first-type printed circuit board in the wearable electronic device shown in FIG. 1 in a top view direction;
FIG. 3 is a schematic cross-sectional view of another wearable electronic device in an explosive state according to an embodiment of this application;
FIG. 4 is a schematic cross-sectional view of the printed circuit board in FIG. 2 at a top view angle;
FIG. 5 is a schematic cross-sectional view of another monopole antenna according to an embodiment of this application;
FIG. 6 is a schematic cross-sectional view of a first antenna structure being an inverted F antenna according to an embodiment of this application;
FIG. 7 is a schematic cross-sectional view of a first antenna structure being a loop antenna according to an embodiment of this application;
FIG. 8 is a schematic cross-sectional view of a first antenna structure being a planar inverted F antenna according to an embodiment of this application;
FIG. 9 is a schematic cross-sectional view of an A-A direction in FIG. 8;
FIG. 10 is a schematic cross-sectional view of a second antenna structure in FIG. 2 at a top view angle;
FIG. 11 is a schematic cross-sectional view of a second-type second antenna structure at a top view angle according to an embodiment of this application;
FIG. 12 is a schematic cross-sectional view of a third-type second antenna structure at a top view angle according to an embodiment of this application;
FIG. 13 is a schematic cross-sectional view of a fourth-type second antenna structure at a top view angle according to an embodiment of this application;
FIG. 14 is a schematic cross-sectional view of a fifth-type second antenna structure at a top view angle according to an embodiment of this application;
FIG. 15 is a current diagram of connection between a first antenna structure and a second antenna structure via an electrical connection structure in FIG. 1;
FIG. 16 is a diagram of another combination of a first antenna structure, an electrical connection structure, and a second antenna structure according to an embodiment of this application;
FIG. 17 is a diagram of still another combination of a first antenna structure, an electrical connection structure, and a second antenna structure according to an embodiment of this application;
FIG. 18 is a schematic cross-sectional view of a second-type printed circuit board at a top view angle according to an embodiment of this application;
FIG. 19 is a schematic cross-sectional view of a third-type printed circuit board at a top view angle according to an embodiment of this application;
FIG. 20 is a schematic cross-sectional view of a fourth-type printed circuit board at a top view angle according to an embodiment of this application;
FIG. 21 is a schematic cross-sectional view of a fifth-type printed circuit board at a top view angle according to an embodiment of this application;
FIG. 22 is a schematic cross-sectional view of a sixth-type printed circuit board at a top view angle according to an embodiment of this application;
FIG. 23 is a schematic cross-sectional view of a seventh-type printed circuit board at a top view angle according to an embodiment of this application;
FIG. 24 is a schematic cross-sectional view of an eighth-type printed circuit board at a top view angle according to an embodiment of this application;
FIG. 25 is a schematic cross-sectional view of a ninth-type printed circuit board at a top view angle according to an embodiment of this application;
FIG. 26 is a schematic cross-sectional view of a first-type circuit board assembly according to an embodiment of this application;
FIG. 27 is a schematic cross-sectional view of a second-type circuit board assembly according to an embodiment of this application;
FIG. 28 is a schematic cross-sectional view of a third-type circuit board assembly according to an embodiment of this application;
FIG. 29 is a diagram of a simple model of a wearable electronic device according to an embodiment of this application;
FIG. 30 is a schematic cross-sectional view of the simple model in FIG. 29;
FIG. 31 is a diagram of simulation of radiation efficiency in different scenarios;
FIG. 32 is a diagram of electric field distribution in a Case 1 scenario;
FIG. 33 is a diagram of electric field distribution in a Case 2 scenario; and
FIG. 34 is a diagram of electric field distribution in a Case 3 scenario.

Descriptions of reference numerals:
100. Wearable electronic device;
10. Housing;
11. Upper housing component; 12. Lower housing component; 121. Protruding through hole; 122. Contact surface;
20. Antenna apparatus;
21. First antenna structure; 211. First stub; 212. Second stub;
22. Second antenna structure; 221. Avoidance structure;
30. Electrical connection structure;
41. Floor structure;
42. First electrical connection region; 43. Second electrical connection region;
50. Printed circuit board; 51. Main board body;
60. Circuit board assembly; 61. First circuit board; 62. Second circuit board; 63. Electrical connector;
70. Battery; 80. Sensor.

### DESCRIPTION OF EMBODIMENTS

Common wearable electronic devices include a watch, a band, a headset, glasses, a pendant, and the like. The watch is used as an example. The watch integrates a communication function, and has a built-in antenna to transmit or receive an electromagnetic signal. In a related technology, the wearable electronic device includes a housing, a printed circuit board, and an antenna. The printed circuit board and the antenna are disposed inside the housing. The antenna is placed on the printed circuit board. A feed point and a ground point of the antenna are separately connected to the printed circuit board. The printed circuit board is also used as a ground plate of the antenna. However, the wearable device such as the watch is close to a human body during usage, and an electromagnetic wave emitted by the antenna is greatly absorbed by the human body. Consequently, antenna efficiency is reduced.

In view of this, an embodiment of this application provides a wearable electronic device 100. Electric field distribution near a human body is changed, so that a proportion of normal components (perpendicular to a surface of the human body) in the electric field distribution near the human body is mainly increased, thereby increasing difficulty of entering the human body by an electric field, reducing absorption of electromagnetic energy by the human body, and improving antenna efficiency.

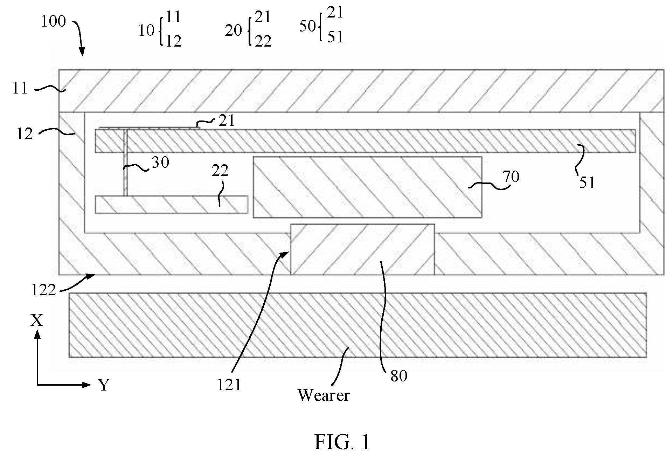

FIG. 1 is a schematic cross-sectional view of a wearable electronic device in an explosive state according to an embodiment of this application.

Refer to FIG. 1. The wearable electronic device 100 may include a housing 10, an antenna apparatus 20, a battery 70, a sensor 80, and a printed circuit board 50. The antenna apparatus 20, the battery 70, and the printed circuit board 50 are disposed inside the housing 10. The housing 10 includes a protruding through hole 121 and a contact surface 122. The contact surface 122 is configured to be in contact with a wearer, and the protruding through hole 121 communicates the inside and the outside of the housing 10. The sensor 80 is disposed inside the protruding through hole 121. In other words, the sensor 80 is exposed outside the housing 10 through the protruding through hole 121. The sensor 80 is configured to be in contact with or not in contact with the wearer, to implement functions such as blood pressure and heart rate. The antenna apparatus 20 is configured to transmit or receive an electromagnetic wave, to implement a communication function of the wearable electronic device. The battery 70 is configured to supply power to the wearable electronic device 100, so that the wearable electronic device 100 operates normally.

For example, the sensor 80 may be a PPG sensing apparatus. Certainly, the sensor 80 may alternatively be another sensing apparatus, and details are not described herein.

It should be noted that the wearable electronic device 100 may further include another component that enables a function to be complete, for example, may further include a display and a button.

For example, as shown in FIG. 1, the housing 10 includes an upper housing component 11 and a lower housing component 12. The upper housing component 10 and the lower housing component 10 are connected to form a cavity. The cavity is configured to accommodate components that enable functions of the wearable electronic device 100 to be complete, such as the antenna apparatus 20, the battery 70, and the printed circuit board 50.

It should be noted that the housing 10 may alternatively be of another structure. For example, the housing 10 may alternatively include a middle frame, a front cover, and a rear cover, two opposite ends of the middle frame are respectively connected to the front cover and the rear cover, and the middle frame, the rear cover, and the front cover form a cavity that accommodates components such as the antenna apparatus 20, the battery 70, and the printed circuit board 50.

The housing 10 may be made of a non-metallic material. For example, at least a part of the upper housing component 11 and at least a part of the lower housing component 12 may both be made of plastic, which can reduce a weight of the housing 10, and help achieve a lightweight design of the wearable electronic device 100. For example, both the upper housing component 11 and the lower housing component 12 may be made of plastic, which can reduce the weight of the housing 10. In addition, the upper housing component 11 and the lower housing component 12 can be manufactured in an integrated manner through injection molding. However, in some other embodiments, the housing 10 may alternatively be made of a metal material and a non-metallic material. In still some other embodiments, the housing 10 may alternatively be made of a metal material.

As shown in FIG. 1, in a thickness direction (for example, an X direction in FIG. 1) of the housing 10, the lower housing component 12 is located between the wearer and the upper housing component 11. Therefore, a surface that is of the lower housing component 12 and that is in contact with the wearer is the contact surface 122.

As shown in FIG. 1, in the thickness direction (for example, the X direction in FIG. 1) of the housing 10, the protruding through hole 121 penetrates the lower housing component 12, to ensure that the sensor 80 can be exposed, and enable the sensor 80 to collect a physiological parameter of the wearer, so as to implement functions such as blood pressure detection and heart rate detection.

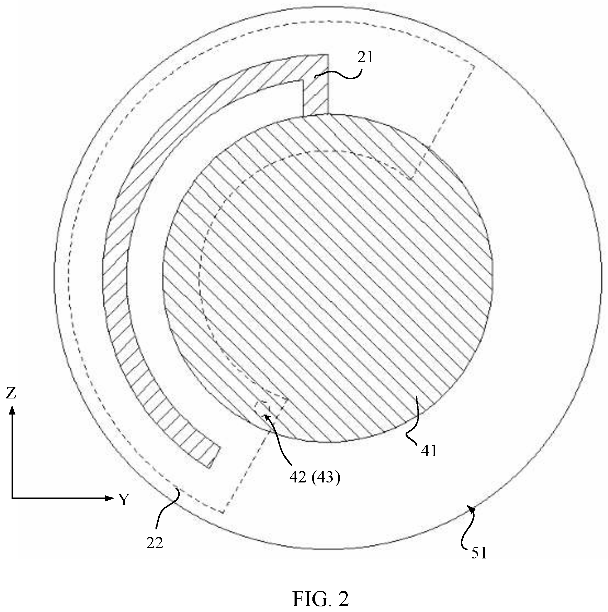

FIG. 2 is a schematic cross-sectional view of a first-type printed circuit board in the wearable electronic device shown in FIG. 1 in a top view direction.

Refer to FIG. 1. The antenna apparatus 20 includes a first antenna structure 21 and a second antenna structure 22. Both the first antenna structure 21 and the second antenna structure 22 are configured to generate resonance. In the thickness direction (for example, the X direction in FIG. 1) of the housing 10, the first antenna structure 21, the second antenna structure 22, and the contact surface 122 are sequentially arranged, and the first antenna structure 21 and the second antenna structure 22 are disposed at an interval. In the thickness direction (for example, the X direction in FIG. 1) of the housing 10, a projection of the second antenna structure 22 at least partially overlaps a projection of the first antenna structure 21.

During operation of the antenna apparatus 20, both the first antenna structure 21 and the second antenna structure 22 generate resonance. In this way, the electromagnetic wave is received or transmitted. In addition, a polarization deflection apparatus is formed, and the polarization deflection apparatus may change some horizontal components (parallel to a surface of a human body) in electric field distribution near the human body to normal components (perpendicular to the surface of the human body), so that a proportion of normal components in the electric field distribution near the wearer increases, thereby increasing difficulty of entering the human body by an electric field, reducing absorption of electromagnetic energy by the human body, and improving antenna efficiency. In addition, the second antenna structure 22 may further equivalently increase an antenna clearance, and may further improve antenna performance.

Difficulty of entering the human body by a vertical electric field is greater than difficulty of entering the human body by a horizontal electric field. The vertical electric field may be understood as an electric field formed by normal components, and the horizontal electric field may be understood as an electric field formed by horizontal components.

As shown in FIG. 2, the printed circuit board 50 includes the first antenna structure 21 and a main board body 51. In the thickness direction (for example, the X direction in FIG. 1) of the housing 10, the first antenna structure 21 is disposed on a side (as shown in FIG. 1) that is of the main board body 51 and that faces away from the second antenna structure 22. However, in some embodiments, in the thickness direction of the housing 10, the first antenna structure 21 may alternatively be disposed between the main board body 51 and the second antenna structure 22. In other words, the first antenna structure 21 may alternatively be disposed on the other side that is of the main board body 51 and that faces the second antenna structure 22.

In some embodiments, one part of the first antenna structure 21 is in contact with the main board body 51, and the other part of the first antenna structure 21 is disposed at an interval from the main board body 51 in the thickness direction (for example, the X direction in FIG. 1) of the housing 10. However, in some other embodiments, the first antenna structure 21 and the main board body 51 may alternatively be disposed at an interval in the thickness direction of the housing 10. In other words, the first antenna structure 21 may alternatively not be in contact with the main board body 51. In this case, the first antenna structure 21 may be located on a first side or a second side of the main board body 51, the first side of the main board body 51 faces the upper housing component 11 in the thickness direction of the housing 10, and the second side of the main board body 51 faces the lower housing component 12 in the thickness direction of the housing 10.

In conclusion, refer to FIG. 1. In the thickness direction (for example, the X direction in FIG. 1) of the housing 10, the first antenna structure 21 is located above or below the main board body 51, and when both the first antenna structure 21 and the second antenna structure 22 resonate, the polarization deflection apparatus may be formed, so that the proportion of normal components in the electric field distribution near the wearer increases, thereby reducing the absorption of the electromagnetic energy by the human body. Furthermore, when the first antenna structure 21 is disposed above the main board body 51, in the thickness direction of the housing 10, a spacing between the first antenna structure 21 and the second antenna structure 22 increases, which can further reduce the absorption of electromagnetic energy by the human body.

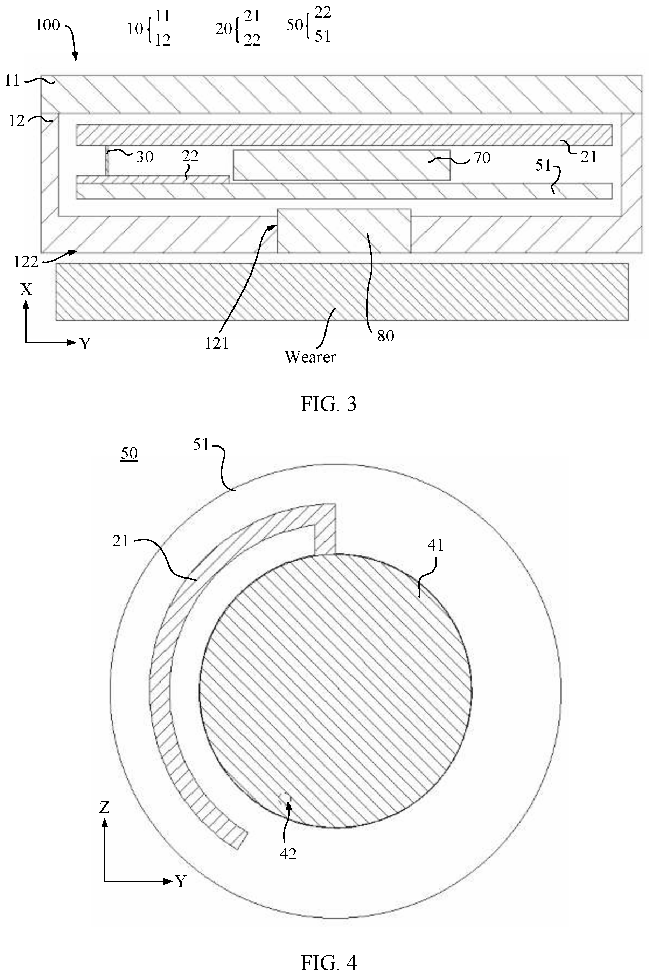

It should be noted that, the printed circuit board 50 may be formed by the first antenna structure 21 and the main board body 51; in some embodiments, the printed circuit board 50 may alternatively be formed by the second antenna structure 22 and the main board body 51, for example, as shown in FIG. 3. FIG. 3 is a schematic cross-sectional view of another wearable electronic device in an explosive state according to an embodiment of this application.

Specifically, a difference between FIG. 3 and FIG. 1 lies in that the printed circuit board 50 may alternatively include the second antenna structure 22 and the main board body 51. In the thickness direction (for example, an X direction in FIG. 3) of the housing 10, the second antenna structure 22 is disposed on a side that is of the main board body 51 and that faces the first antenna structure 21. In other words, the second antenna structure 22 is located between the first antenna structure 21 and the main board body 51.

In some embodiments, one part of the second antenna structure 22 may be in contact with the main board body 51, and the other part of the second antenna structure 22 is disposed at an interval from the main board body 51 in the thickness direction (for example, the X direction in FIG. 3) of the housing 10. However, in some other embodiments, the second antenna structure 22 may alternatively be disposed at an interval from the main board body 51 in the thickness direction (for example, the X direction in FIG. 3) of the housing 10, and the second antenna structure 22 is electrically connected to the main board body 51.

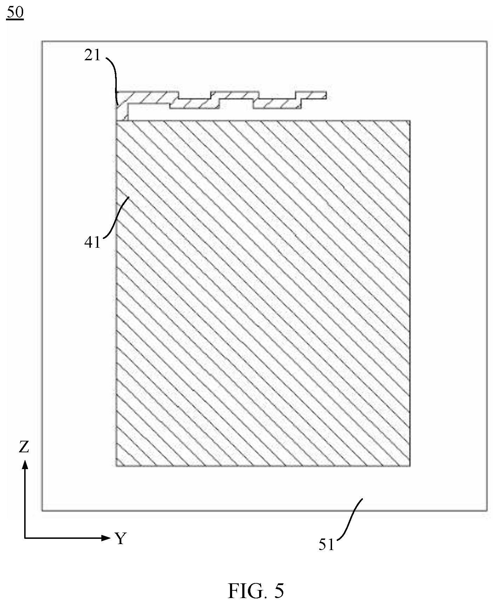

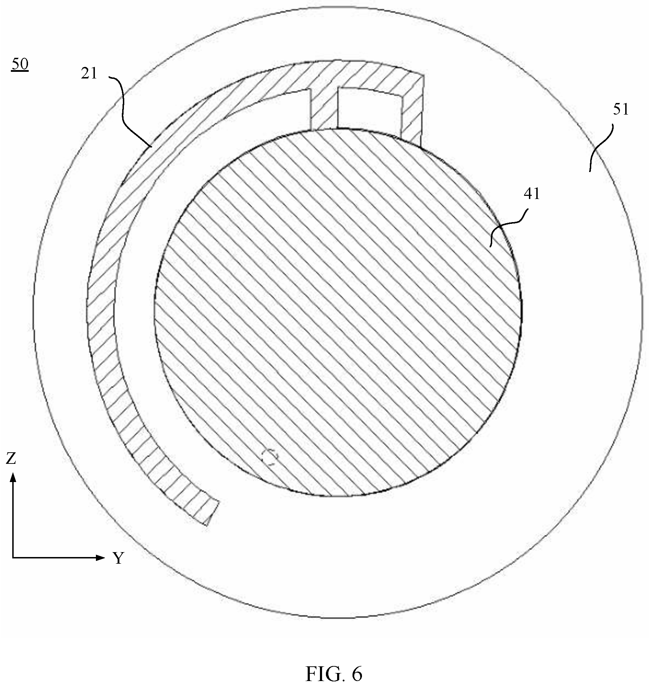

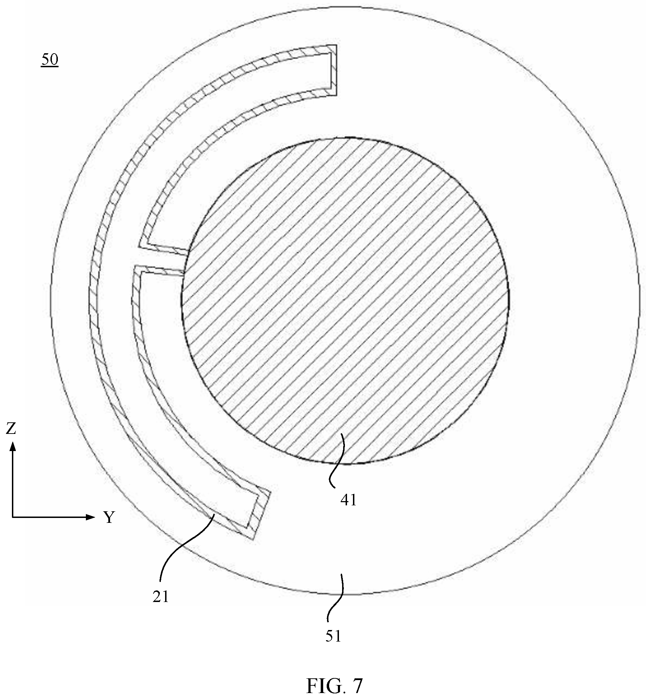

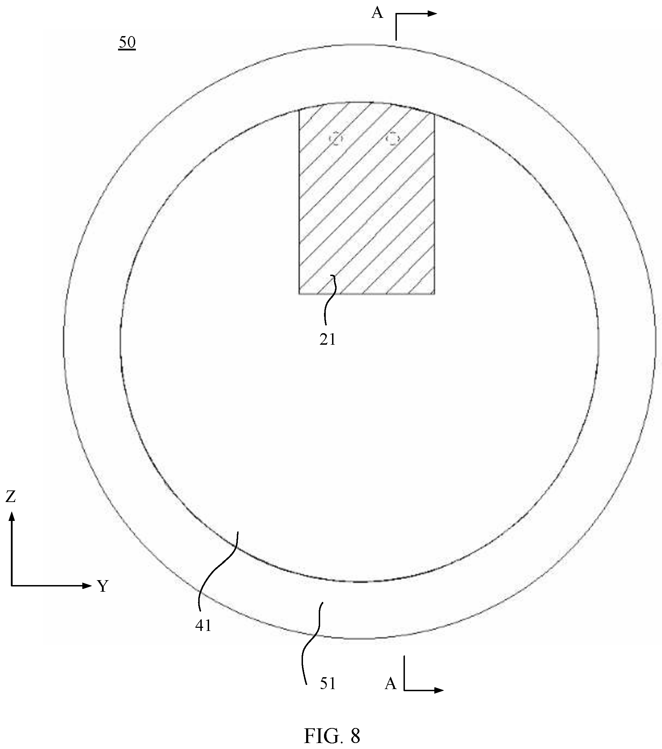

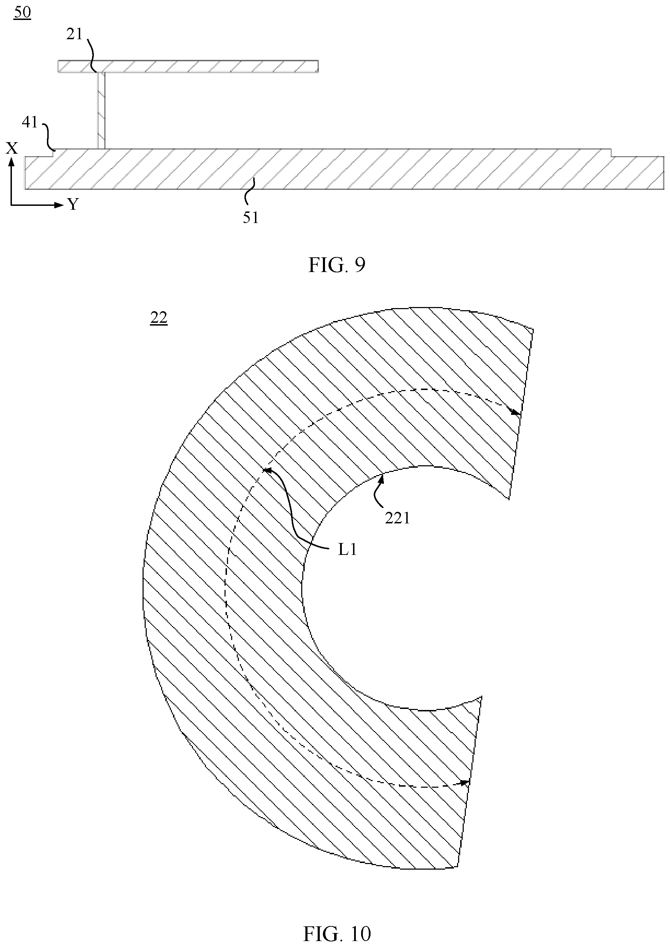

FIG. 4 is a schematic cross-sectional view of the printed circuit board in FIG. 2 at a top view angle. FIG. 5 is a schematic cross-sectional view of another monopole antenna according to an embodiment of this application. FIG. 6 is a schematic cross-sectional view of a first antenna structure being an inverted F antenna according to an embodiment of this application. FIG. 7 is a schematic cross-sectional view of a first antenna structure being a loop antenna according to an embodiment of this application. FIG. 8 is a schematic cross-sectional view of a first antenna structure being a planar inverted F antenna according to an embodiment of this application. FIG. 9 is a schematic cross-sectional view of an A-A direction in FIG. 8.

For example, the first antenna structure 21 may be a monopole antenna. The monopole antenna may be of the structure shown in FIG. 4, or the monopole antenna may alternatively be of another structure. For example, as shown in FIG. 5, the first antenna structure 21 is a snake-shaped monopole antenna. In some implementations, as shown in FIG. 6, the first antenna structure 21 may alternatively be the inverted F antenna. In some other implementations, as shown in FIG. 7, the first antenna structure 21 may alternatively be the loop antenna. In still some other implementations, as shown in FIG. 8 and FIG. 9, the first antenna structure 21 may alternatively be the planar inverted F antenna.

The second antenna structure 22 is made of a conductive material, ensuring that such a radiator can generate resonance. For example, a material of the second antenna structure 22 may be a copper foil, a hand-torn steel, a thin film with good conductivity, or a printed conductive material layer.

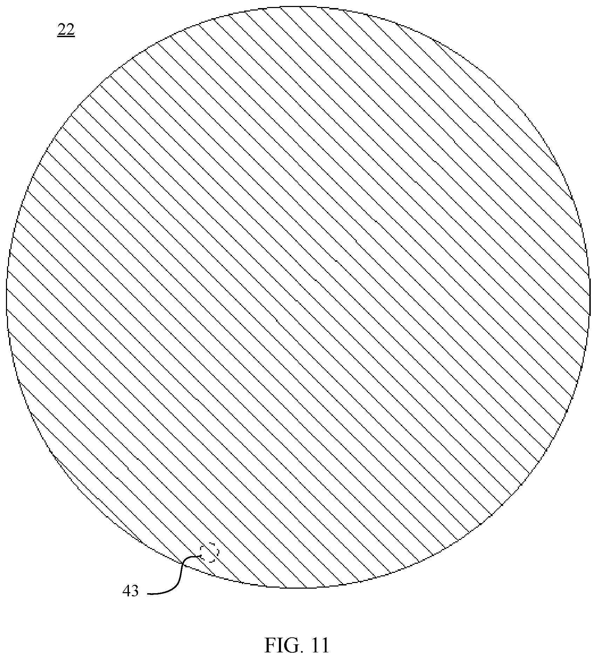

FIG. 10 is a schematic cross-sectional view of the second antenna structure in FIG. 2 at a top view angle. FIG. 11 is a schematic cross-sectional view of a second-type second antenna structure at a top view angle according to an embodiment of this application.

In some possible implementations, refer to FIG. 10. The second antenna structure 22 may be a stub structure. The stub structure may be understood as a structure other than a ring structure, or the stub structure may be understood as an unclosed ring structure.

A specific structure of the stub structure is not specifically limited herein. For example, as shown in FIG. 10, the stub structure may be a semicircular ring structure. Certainly, the stub structure may alternatively be a structure such as a quarter or three fourths of a circular ring. In addition, the stub structure may be a part of a circular ring structure, or the stub structure may alternatively be a part of a rectangular ring structure or a part of a ring structure of another shape.

In some implementations, as shown in FIG. 11, the stub structure may alternatively be a circular plate structure. Certainly, the stub structure may alternatively be a plate structure of another shape such as a rectangle or a semicircle. In some other implementations, the stub structure may alternatively be a half of a regular-shaped plate structure such as a circle or a rectangle.

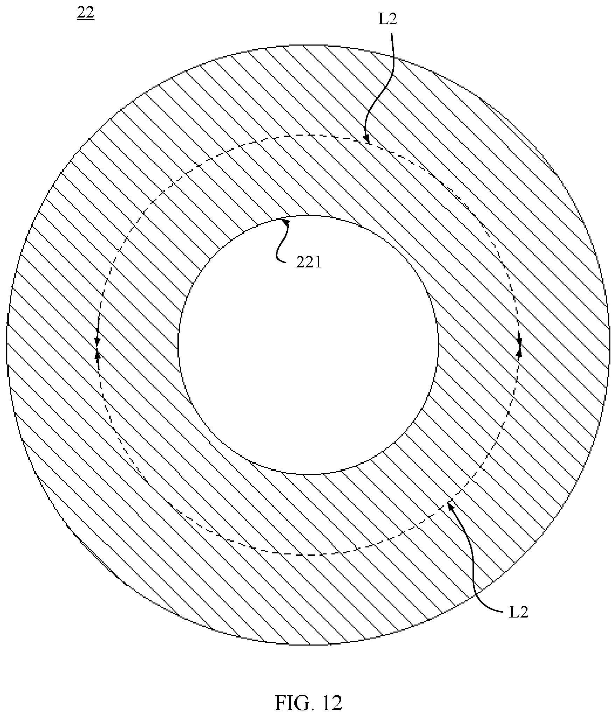

It should be noted that, the second antenna structure 22 may be either of the stub structures shown in FIG. 11 and FIG. 12, or may alternatively be a stub structure of another shape.

It should be further noted that, the second antenna structure 22 may be the stub structure; in some other possible implementations, the second antenna structure 22 may alternatively be a closed ring structure.

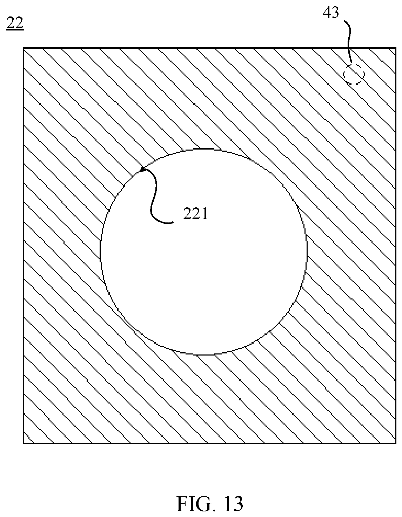

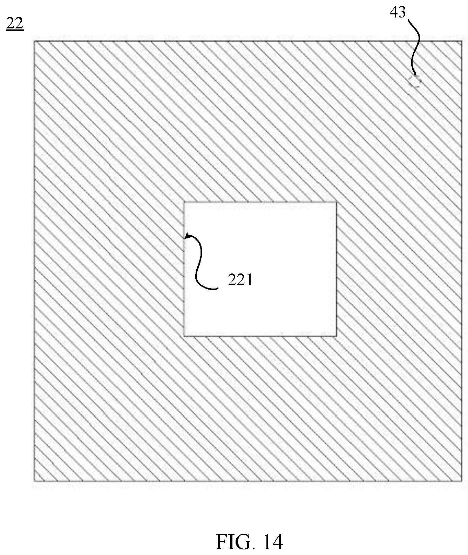

FIG. 12 is a schematic cross-sectional view of a third-type second antenna structure at a top view angle according to an embodiment of this application. FIG. 13 is a schematic cross-sectional view of a fourth-type second antenna structure at a top view angle according to an embodiment of this application. FIG. 14 is a schematic cross-sectional view of a fifth-type second antenna structure at a top view angle according to an embodiment of this application.

In some implementations, as shown in FIG. 12, the second antenna structure 22 may be a circular ring structure. In some other implementations, as shown in FIG. 13, the second antenna structure 22 is a ring structure, an outer edge of the second antenna structure 22 is a rectangle, and an inner edge of the second antenna structure 22 is a circle. In still some other implementations, as shown in FIG. 14, the second antenna structure 22 is a ring structure, and both an outer edge and an inner edge of the second antenna structure 22 are rectangles.

It should be noted that, the second antenna structure 22 may be one of the ring structures of three shapes shown in FIG. 12 to FIG. 14, or may alternatively be a ring structure of another shape.

When the height of the battery 70 in the thickness direction of the housing 10 is greater than the spacing between the first antenna structure 21 and the second antenna structure 22, if the battery 70 is placed between the first antenna structure 21 and the second antenna structure 22, the battery 70 presses against the first antenna structure 21 and the second antenna structure 22. Based on this, in some possible implementations, the second antenna structure 22 may include an avoidance structure 221. The avoidance structure 221 is configured to avoid the battery 70, so that a projection of the battery 70 in the thickness direction of the housing 10 does not overlap a projection of the second antenna structure 22 in the thickness direction of the housing 10, and the height of the battery 70 may be greater than the spacing between the first antenna structure 21 and the second antenna structure 22 in the thickness direction of the housing 10.

A specific structure of the avoidance structure 221 is not limited herein. In some implementations, the avoidance structure 221 may be an avoidance notch, for example, as shown in FIG. 10. In some other implementations, the avoidance structure 221 may be an avoidance through hole that penetrates the second antenna structure 22, for example, as shown in FIG. 13 or FIG. 14.

It should be noted that the avoidance structure 221 may avoid another component while avoiding the battery 70. In addition, when the battery 70 is not disposed near the second antenna structure 22, the second antenna structure 22 may also include the avoidance structure 221. In this case, the avoidance structure 221 may be configured to avoid another component.

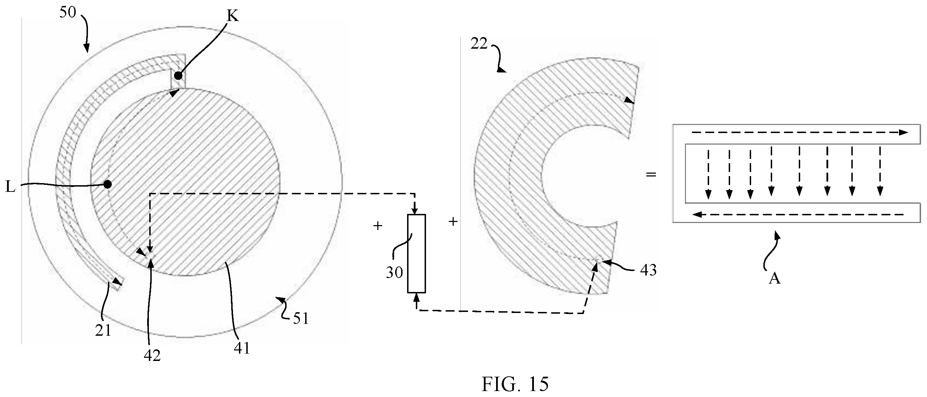

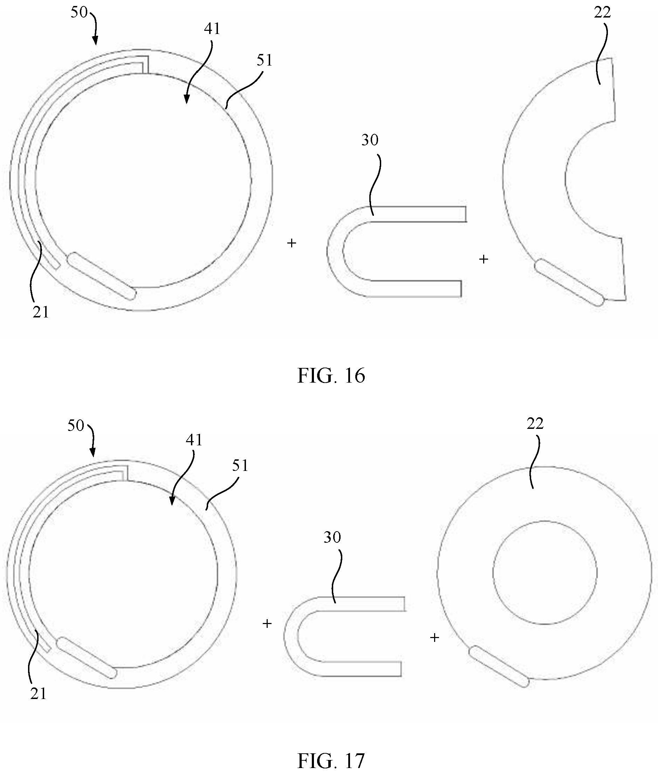

FIG. 15 is a current diagram of connection between the first antenna structure and the second antenna structure via the electrical connection structure in FIG. 1. FIG. 16 is a diagram of another combination of a first antenna structure, an electrical connection structure, and a second antenna structure according to an embodiment of this application. FIG. 17 is a diagram of still another combination of a first antenna structure, an electrical connection structure, and a second antenna structure according to an embodiment of this application.

For example, refer to FIG. 1 and FIG. 15. The wearable electronic device 100 includes an electrical connection structure 30, and the first antenna structure 21 is electrically connected to the second antenna structure 22 via the electrical connection structure 30. In this way, the absorption of the electromagnetic energy by the human body can be further reduced, and the antenna efficiency can be further improved. In addition, when the wearable electronic device 100 is light and thin, it can also be ensured that the antenna efficiency meets a requirement.

A connection relationship among the first antenna structure 21, the electrical connection structure 30, and the second antenna structure 22 may be equivalent to that shown by A in FIG. 15. An upper arm of A is equivalent to the first antenna structure 21, a lower arm of A is equivalent to the second antenna structure 22, and a vertical arm between the upper arm and the lower arm is equivalent to the electrical connection structure 30. Therefore, during operation of the antenna apparatus 20, a current on the first antenna structure 21 and a current on the second antenna structure 22 are reverse to each other, so that an electric field between the first antenna structure 21 and the second antenna structure 22 mainly includes normal components. Therefore, the proportion of normal components in the electric field distribution near the human body can be increased, and the absorption of the electromagnetic energy by the human body can be reduced, thereby improving the antenna efficiency.

It should be noted that, within an allowed range, a larger spacing between the first antenna structure 21 and the second antenna structure 22 in the thickness direction of the housing 10 indicates a larger antenna clearance, so that the antenna performance can be further improved.

In some possible implementations, the electrical connection structure 30 may be further configured to generate resonance with both the first antenna structure 21 and the second antenna structure 22, so that the electrical connection structure 30 can also transmit and receive the electromagnetic wave, thereby helping further improve the antenna efficiency.

In embodiments of this application, a specific structure of the electrical connection structure 30 is not limited herein. The electrical connection structure 30 may be a spring, a probe, a flexible printed circuit, or the like.

In conclusion, a structure of the electrical connection structure 30, a structure of the first antenna structure 21, and a structure of the second antenna structure 22 may be of various types, and a plurality of first antenna structures 21, a plurality of electrical connection structures 30, and a plurality of second antenna structures 22 may be freely combined. For example, in some implementations, the first antenna structure 21 is a monopole antenna, the electrical connection structure 30 is a probe, and the second antenna structure 22 is a stub structure. In some other implementations, as shown in FIG. 16, the first antenna structure 21 is a monopole antenna, the second antenna structure 22 is a stub structure, and the electrical connection structure 30 is a flexible printed circuit. In still some other implementations, as shown in FIG. 17, the first antenna structure 21 is a monopole antenna, the second antenna structure 22 is a circular ring structure, and the electrical connection structure 30 is a flexible printed circuit.

For example, as shown in FIG. 1, the electrical connection structure 30 is separated from the first antenna structure 21 and the second antenna structure 22, and may be electrically connected to the first antenna structure 21 and the second antenna structure 22 in a manner such as welding or clamping. However, the electrical connection structure 30 and at least one of the first antenna structure 21 and the second antenna structure 22 may alternatively be of an integrated structure. The following uses examples to describe cases in which the electrical connection structure 30 and one or both of the first antenna structure 21 and the second antenna structure 22 form an integrated structure.

In some possible implementations, as shown in FIG. 16 or FIG. 17, the first antenna structure 21 and the electrical connection structure 30 may be of an integrated structure. In this way, stability of a connection between the first antenna structure 21 and the electrical connection structure 30 can be improved. In addition, production efficiency of the wearable electronic device 100 can be further improved.

In some other possible implementations, the second antenna structure 22 and the electrical connection structure 30 may be of an integrated structure. In this way, stability of a connection between the second antenna structure 22 and the electrical connection structure 30 can be improved. In addition, production efficiency of the wearable electronic device 100 can be further improved.

In still other possible implementations, the first antenna structure 21 and the second antenna structure 22 and the electrical connection structure 30 may alternatively be of an integrated structure. In this way, stability of connections between the electrical connection structure 30 and the first antenna structure 21 and between the electrical connection structure 30 and the second antenna structure 22 can be improved. In addition, production efficiency of the wearable electronic device 100 can be further improved.

In some possible implementations, the antenna apparatus 20 may satisfy a relational expression: L+H=kλn. L is the length of the second antenna structure 22, H is the length of the electrical connection structure 30, λ is a wavelength corresponding to an operating frequency band of the antenna apparatus 20 in free space, k is a positive integer, and n is greater than or equal to 1/4. In this way, when both the first antenna structure 21 and the second antenna structure 22 generate resonance, the electric field distribution near the wearer can be changed, to ensure that the electric field entering the human body is reduced, thereby reducing the absorption of the electromagnetic energy by the human body. In addition, n is greater than or equal to 1/4, which can further reduce the absorption of the electromagnetic energy by the human body.

A value of n is not limited herein. For example, n may be equal to 1/4. It should be noted that, when engineering matching is not considered, a value of n may alternatively be less than 1/4.

When the second antenna structure 22 is a stub structure, the length of the second antenna structure 22 may be understood as an equivalent length of a connection line between midpoints at two opposite ends of the second antenna structure 22 in an extension direction (or a length direction) of the second antenna structure 22. For example, as shown in FIG. 10, the stub structure is a circular ring structure with a notch, and the length of the second antenna structure 22 is an equivalent length L1 in FIG. 10.

When the second antenna structure 22 is a closed ring structure, the length of the second antenna structure 22 may be understood as an equivalent length of a connection line, in a circumferential direction of the second antenna structure 22, between centers at two opposite ends of each of two symmetric parts into which the second antenna structure 22 is divided. For example, as shown in FIG. 12, the second antenna structure 22 is the circular ring structure, and the length of the second antenna structure 22 is an equivalent length L2 in FIG. 12.

In some implementations, in the thickness direction of the housing 10, the electrical connection structure 30 may be located between the first antenna structure 21 and the second antenna structure 22, and H is equal to the spacing between the first antenna structure 21 and the second antenna structure 22 in the thickness direction of the housing 10, so that the electrical connection structure 30 does not affect the thickness of the housing 10, thereby helping a thinning design of the wearable electronic device 100.

In some other implementations, H may alternatively be greater than the spacing between the first antenna structure 21 and the second antenna structure 22 in the thickness direction of the housing 10. In this case, the electrical connection structure 30 may be located between the first antenna structure 21 and the second antenna structure 22, or may not be located between the first antenna structure 21 and the second antenna structure 22.

In embodiments of this application, the wearable electronic device 100 may further include a floor structure 41. Refer to FIG. 15. The floor structure 41 has a first electrical connection region 42, the second antenna structure 22 has a second electrical connection region 43, and the first electrical connection region 42 is electrically connected to the second electrical connection region 43 via the electrical connection structure 30. In this arrangement, the first antenna structure 21 can be stably electrically connected to the second antenna structure 22 via the floor structure 41, which helps ensure stability of operation of the antenna apparatus 20.

Specifically, as shown in FIG. 4, the main board body 51 includes the floor structure 41. In other words, at least a part of the main board body 51 is used as the floor structure 41, so that the antenna apparatus 20 can be grounded, and the first antenna structure 21 can be electrically connected to the electrical connection structure 30. In addition, using at least the part of the main board body 51 as the floor structure 41 can improve utilization of the main board body 51, thereby helping reduce a quantity of parts of the wearable electronic device 100.

In some implementations, the first antenna structure 21 may further include a ground point, and the ground point is electrically connected to the floor structure 41, to implement grounding of the antenna apparatus 20. In some other implementations, the second antenna structure 22 may alternatively include a ground point, and the ground point is electrically connected to the floor structure 41, to implement grounding of the antenna apparatus 20. In still some other implementations, the electrical connection structure 30 may alternatively include a ground point, and the ground point is electrically connected to the floor structure 41, to implement grounding of the antenna apparatus 20.

In some possible implementations, a projection of the first electrical connection region 42 at least partially overlaps a projection of the second electrical connection region 43 in the thickness direction of the housing 10, so that the absorption of the electromagnetic energy by the human body can be further reduced, and the antenna efficiency can be further improved.

For example, in the thickness direction (perpendicular to a Z direction and a Y direction in FIG. 2) of the housing 10, the projection of the first electrical connection region 42 overlaps the projection of the second electrical connection region 43. Certainly, in some embodiments, in the thickness direction of the housing 10, the projection of the first electrical connection region 42 may alternatively partially overlap the projection of the second electrical connection region 43.

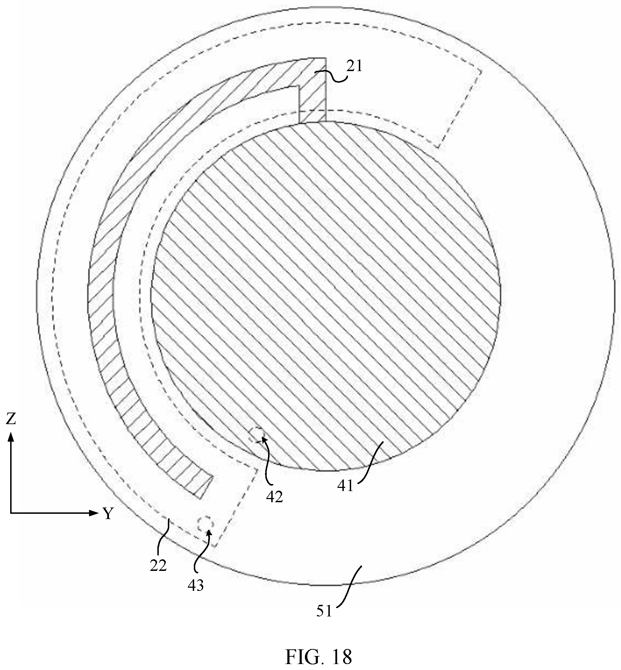

FIG. 18 is a schematic cross-sectional view of a second-type printed circuit board at a top view angle according to an embodiment of this application.

In some other possible implementations, in the thickness direction of the housing 10, the projection of the first electrical connection region 42 may not overlap the projection of the second electrical connection region 43, so that the first electrical connection region 42 and the second electrical connection region 43 are arranged at an interval in a direction perpendicular to the thickness direction of the housing 10 (as shown in FIG. 18).

When the projection of the first electrical connection region 42 does not overlap the projection of the second electrical connection region 43, and the electrical connection structure 30 uses a structure such as a spring plate or a probe, the electrical connection structure 30 may also be electrically connected to the first electrical connection region 42 and the second electrical connection region 43 in a bending manner. In addition, the electrical connection structure 30 may alternatively be a flexible printed circuit, and may also be electrically connected to the first electrical connection region 42 and the second electrical connection region 43.

In some possible implementations, in the thickness direction of the housing 10, a projection of the electrical connection structure 30 may be located within an overlapping region between the projection of the first electrical connection region 42 and the projection of the second electrical connection region 43. In this way, the absorption of the electromagnetic energy by the human body can be further reduced, and the antenna efficiency can be improved. In addition, the structure of the electrical connection structure 30 may be further simplified.

It should be noted that, the projection of the electrical connection structure 30 may be located within the overlapping region between the projection of the first electrical connection region 42 and the projection of the second electrical connection region 43, or one part of the projection of the electrical connection structure 30 may alternatively be located within the overlapping region between the projection of the first electrical connection region 42 and the projection of the second electrical connection region 43, and the other part is located outside the overlapping region between the projection of the first electrical connection region 42 and the projection of the second electrical connection region 43.

In some possible implementations, the electrical connection structure 30 may be electrically connected to a maximum current point of the floor structure 41. In this way, the absorption of the electromagnetic energy by the human body can be further reduced, and the antenna efficiency can be further improved.

It should be noted that, the electrical connection structure 30 may be electrically connected to the maximum current point of the floor structure 41, or may alternatively be electrically connected to another current point that is on the floor structure 41 and that is less than the maximum current point, which can also implement an electrical connection between the first antenna structure 21 and the second antenna structure 22. In addition, to ensure that the first antenna structure 21 is electrically connected to the second antenna structure 22, the electrical connection structure 30 cannot be connected to a current zero point (as shown by L in FIG. 15) of the floor structure 41. The current zero point L in FIG. 15 is merely used as an example, and a specific position is not limited.

In some possible implementations, in the thickness direction (perpendicular to the Z direction and the Y direction in FIG. 2) of the housing 10, the projection of the second antenna structure 22 may include the projection of the first antenna structure 21, so that the projection of the first antenna structure 21 is located inside the projection of the second antenna structure 22. In this way, the electric field entering the human body can be further reduced, and the absorption of the electromagnetic energy by the human body can be further reduced, thereby helping further improve the antenna efficiency.

Specifically, in the thickness direction of the housing 10, the projection of the first antenna structure 21 is located inside the projection of the second antenna structure 22, and there is a spacing between an edge of the projection of the first antenna structure 21 and an edge of the projection of the second antenna structure 22 in the direction (for example, a Z direction or a Y direction in FIG. 18) perpendicular to the thickness direction of the housing 10. In other words, an area of the projection of the second antenna structure 22 is far greater than that of the projection of the first antenna structure 21.

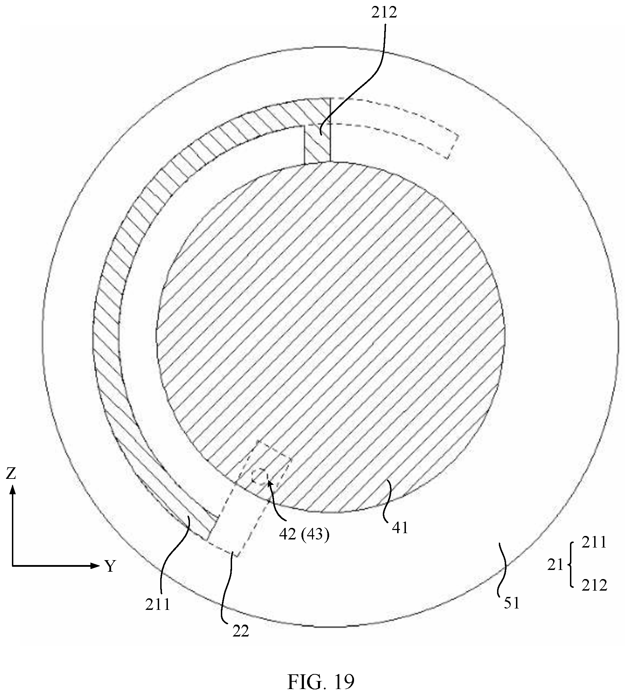

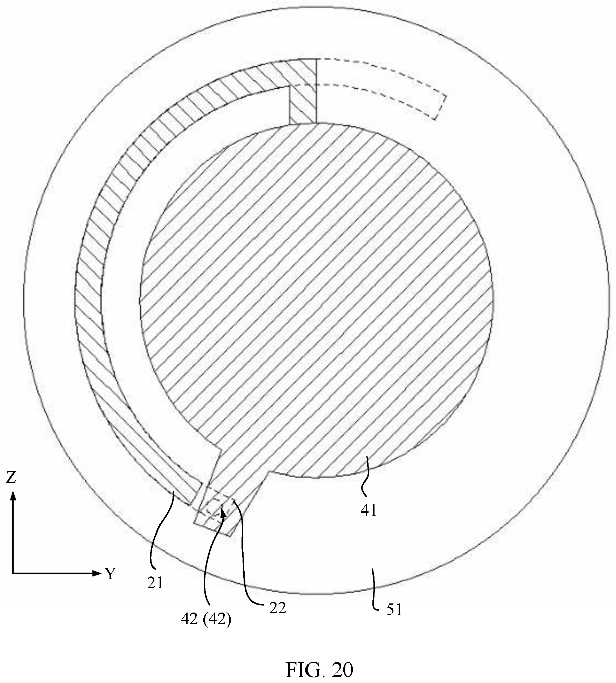

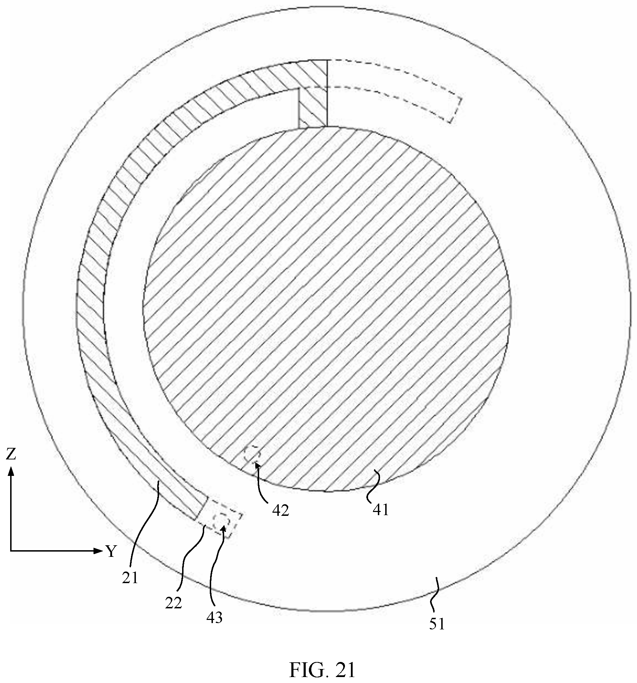

FIG. 19 is a schematic cross-sectional view of a third-type printed circuit board at a top view angle according to an embodiment of this application. FIG. 20 is a schematic cross-sectional view of a fourth-type printed circuit board at a top view angle according to an embodiment of this application. FIG. 21 is a schematic cross-sectional view of a fifth-type printed circuit board at a top view angle according to an embodiment of this application.

In some implementations, in the thickness direction of the housing 10, at least two edges of the projection of the first antenna structure 21 are flush with the edge of the projection of the second antenna structure 22, which can also implement that the projection of the second antenna structure 22 includes the projection of the first antenna structure 21.

For example, as shown in FIG. 19, the first antenna structure 21 may include a first stub 211 and a second stub 212. A first end of the first stub 211 is connected to a first end of the second stub 212, and a second end of the second stub 212 is connected to the floor structure 41. In the thickness direction of the housing 10, two opposite edges of a projection of the first stub 211 are flush with two edges of the projection of the second antenna structure 22.

As shown in FIG. 19, in the thickness direction of the housing 10, the projection of the first electrical connection region 42 overlaps the projection of the second electrical connection region 43. For example, as shown in FIG. 19, in the thickness direction of the housing 10, one part of the projection of the second antenna structure 22 does not overlap a projection of the floor structure 41, and the other part of the projection of the second antenna structure 22 overlaps the projection of the floor structure 41. Therefore, the projection of the first electrical connection region 42 overlaps the projection of the second electrical connection region 43. In other words, a part of the second antenna structure 22 is extendedly disposed below the floor structure 41.

In some other implementations, as shown in FIG. 20, in the thickness direction of the housing 10, one part of a projection of the floor structure 41 does not overlap the projection of the second antenna structure 22, and the other part of the projection of the floor structure 41 overlaps the projection of the second antenna structure 22. Therefore, the projection of the first electrical connection region 42 overlaps the projection of the second electrical connection region 43. In other words, a part of the floor structure 41 is extendedly disposed above the second antenna structure 22.

In some embodiments, as shown in FIG. 20, in the thickness direction of the housing 10, the projection of the first electrical connection region 42 may not overlap the projection of the second electrical connection region 43.

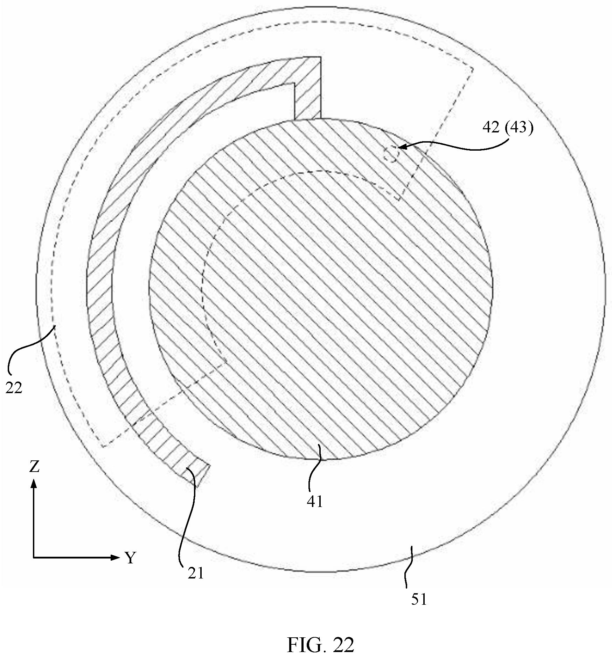

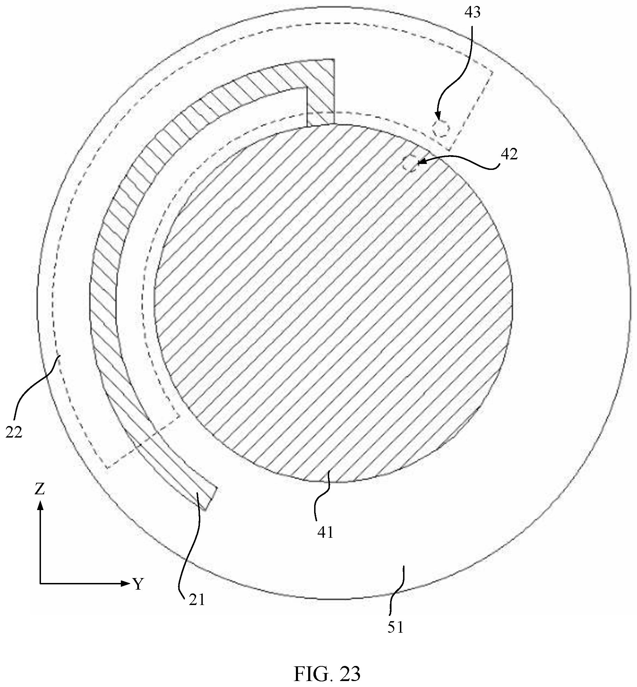

FIG. 22 is a schematic cross-sectional view of a sixth-type printed circuit board at a top view angle according to an embodiment of this application. FIG. 23 is a schematic cross-sectional view of a seventh-type printed circuit board at a top view angle according to an embodiment of this application.

In some other possible implementations, as shown in FIG. 22 and FIG. 23, in the thickness direction of the housing 10, the projection of the second antenna structure 22 may also include a part of the projection of the first antenna structure 21.

Specifically, as shown in FIG. 22 or FIG. 23, in the thickness direction of the housing 10, the projection of the first antenna structure 21 partially overlaps with the projection of the second antenna structure 22.

In some embodiments, as shown in FIG. 22, in the thickness direction of the housing 10, the projection of the first electrical connection region 42 may overlap the projection of the second electrical connection region 43. In some other embodiments, as shown in FIG. 23, in the thickness direction of the housing 10, the projection of the first electrical connection region 42 may not overlap the projection of the second electrical connection region 43.

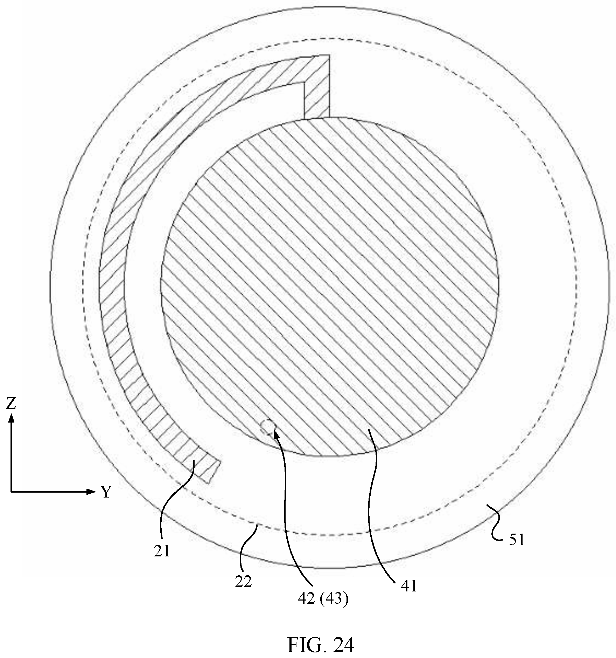

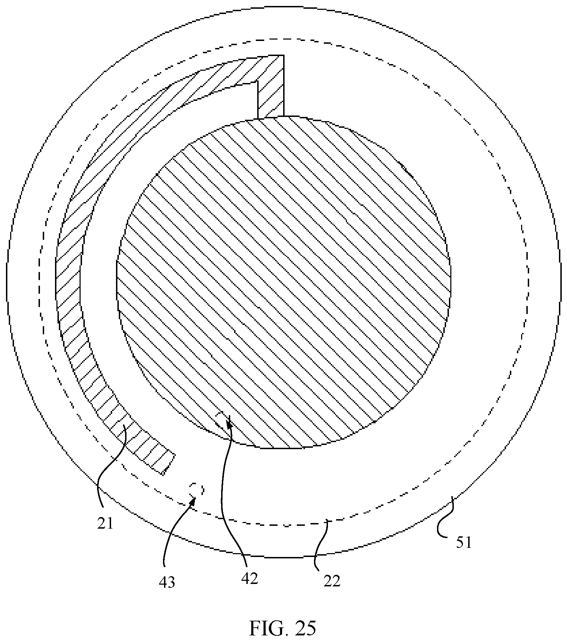

FIG. 24 is a schematic cross-sectional view of an eighth-type printed circuit board at a top view angle according to an embodiment of this application. FIG. 25 is a schematic cross-sectional view of a ninth-type printed circuit board at a top view angle according to an embodiment of this application.

In still another possible implementation, in the thickness direction of the housing 10, the projection of the second antenna structure 22 may further include the projection of the first antenna structure 21 and the projection of the floor structure 41, so that the projection of the first antenna structure 21 and the projection of the floor structure 41 are located inside the projection of the second antenna structure 22. In this way, the electric field entering the human body can be further reduced, and the absorption of the electromagnetic energy by the human body can be further reduced, thereby helping further improve the antenna efficiency.

In some embodiments, as shown in FIG. 24, in the thickness direction of the housing 10, the projection of the first electrical connection region 42 may overlap the projection of the second electrical connection region 43. In some other embodiments, as shown in FIG. 25, in the thickness direction of the housing 10, the projection of the first electrical connection region 42 may not overlap the projection of the second electrical connection region 43.

In some possible implementations, the first antenna structure 21 may include a feed point (as shown by K in FIG. 15), and the feed point may be configured to be electrically connected to the printed circuit board 50, so that the printed circuit board 50 can feed the antenna apparatus 20. In addition, the printed circuit board 50 includes the first antenna structure 21, and the feed point is disposed in the first antenna structure 21, so that difficulty in feeding the antenna apparatus 20 can be reduced.

It should be noted that, the feed point may be disposed in the first antenna structure 21; in some embodiments, the feed point may alternatively be included in the second antenna structure 22. In some other embodiments, the electrical connection structure 30 may alternatively include the feed point.

In the foregoing content, the wearable electronic device 100 includes one printed circuit board 50. However, the wearable electronic device 100 may alternatively include a plurality of printed circuit boards 50.

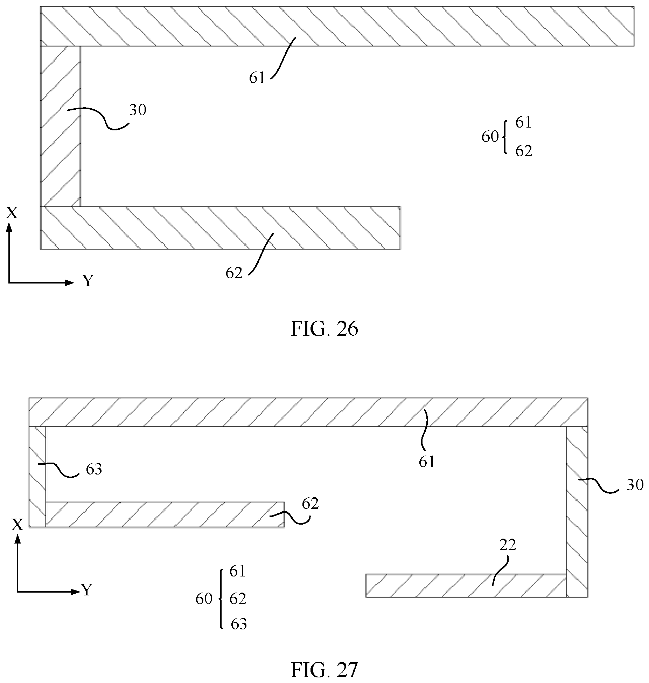

FIG. 26 is a schematic cross-sectional view of a first-type circuit board assembly according to an embodiment of this application.

In some possible implementations, the wearable electronic device 100 includes a circuit board assembly 60. Specifically, as shown in FIG. 26, the circuit board assembly 60 includes a first circuit board 61 and a second circuit board 62 that are electrically connected, the first circuit board 61 includes the first antenna structure 21, and the second circuit board 62 includes the second antenna structure 22.

It may be understood that the first circuit board 61 is equivalent to the printed circuit board 50 in FIG. 1, the first circuit board 61 may further include the main board body 51, and the main board body 51 may include the floor structure 41.

That the second circuit board 62 includes the second antenna structure 22 may be understood as that the second antenna structure 22 may be at least a part of the second circuit board 62. In addition, another component may also be disposed on the second circuit board 62.

As shown in FIG. 26, the first circuit board 61 is electrically connected to the second circuit board 62 via the electrical connection structure 30. The electrical connection structure 30 may implement an electrical connection between the first circuit board 61 and the second circuit board 62, and may also implement the electrical connection between the first antenna structure 21 and the second antenna structure 22.

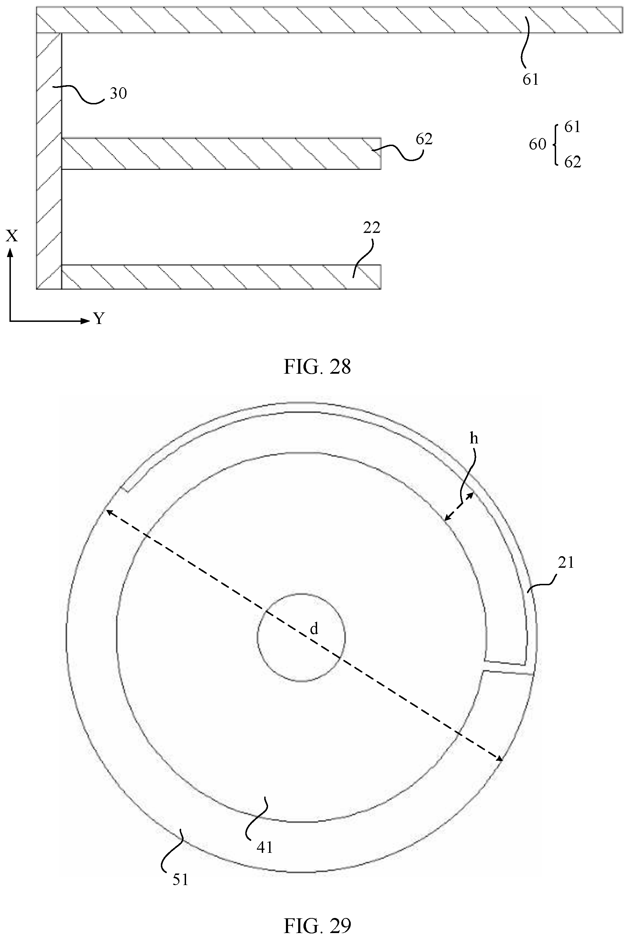

FIG. 27 is a schematic cross-sectional view of a second-type circuit board assembly according to an embodiment of this application. FIG. 28 is a schematic cross-sectional view of a third-type circuit board assembly according to an embodiment of this application.

A difference between FIG. 27 and FIG. 26 lies in that, the circuit board assembly 60 includes the first circuit board 61 and the second circuit board 62 that are electrically connected, the first circuit board 61 includes the first antenna structure 21, and the first circuit board 61, the second circuit board 62, and the second antenna structure 22 are sequentially arranged at an interval in the thickness direction (for example, an X direction in FIG. 27) of the housing 10.

In some implementations, in the thickness direction of the housing 10, the projection of the second antenna structure 22 at least partially overlaps a projection of the second circuit board 62. In some other implementations, in the thickness direction of the housing 10, the projection of the second antenna structure 22 may not overlap a projection of the second circuit board 62.

In some implementations, as shown in FIG. 28, both the second circuit board 62 and the second antenna structure 22 are electrically connected to the first circuit board 61 via the electrical connection structure 30, and the second circuit board 62 and the second antenna structure 22 share the same electrical connection structure 30. In some other implementations, the circuit board assembly 60 may further include an electrical connector 63. The first circuit board 61 is electrically connected to the second circuit board 62 via the electrical connector 63, and the first circuit board 61 is electrically connected to the second antenna structure 22 via the electrical connection structure 30.

The following analyzes, through simple model simulation, a principle of reducing, by the antenna apparatus 20 provided in embodiments of this application, electromagnetic energy absorbed by a human body.

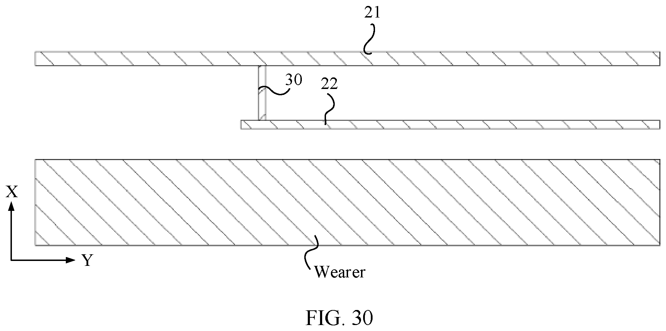

FIG. 29 is a diagram of a simple model of a wearable electronic device according to an embodiment of this application. FIG. 30 is a schematic cross-sectional view of the simple model in FIG. 29.

Overall dimensions of the simple model range from 20 mm x 20 mm x 3 mm to 50 mm x 30 mm x 10 mm, and an antenna clearance ranges from 0.5 mm to 5 mm. For a circular wearable product, dimensions basically range from φ42 mm to φ50 mm. Dimensions of a square wearable device range from 50 mm x 40 mm x 10 mm to 60 mm x 50 mm x 20 mm.

For example, as shown in FIG. 29, d of the simple model may be 20.3 mm. The printed circuit board 50 includes the first antenna structure 21 and the floor structure 41. The floor structure 41 is electrically connected to the second antenna structure 22 via the electrical connection structure 30. A material of the housing 10 is plastic, a material of a dielectric substrate in the main board body 51 is FR4, and a material of the second antenna structure 22 is copper. The first antenna structure 21 is a monopole antenna, and an antenna clearance (as shown by h in FIG. 29) between the first antenna structure 21 and the floor structure 41 is 0.6 mm. The length of the first antenna structure 21 and the length of the second antenna structure 22 each are once 1/4 (about 25 mm) of an electromagnetic wave wavelength corresponding to a Bluetooth frequency band. A distance between the first antenna structure 21 and the human body is 2 mm, and the length of the electrical connection structure 30 is 1.6 mm. The first electrical connection region 42 is located at an edge of the floor structure 41 and is close to the first antenna structure 21. In the thickness direction of the housing 10, the projection of the first electrical connection region 42 overlaps the projection of the second electrical connection region 43, and the projection of the electrical connection structure 30 is located within the overlapping region of the projection of the first electrical connection region 42 and the projection of the second electrical connection region 43.

**Table 1 shows radiation efficiency of a 2.5 GHz antenna in different scenarios.**

| \ | | Case 1 | Case 2 | Case 3 |
|---|---|---|---|---|
| Radiation efficiency (dB) | FS (free space) | -7.03 | -8.51 | -1.63 |
| | With Body (Worn by a human body) | -22.90 | -21.27 | -14.03 |

Case 1 indicates that there is only the first antenna structure 21. Case 2 indicates that the first antenna structure 21 and the second antenna structure 22 coexist, but the first antenna structure 21 and the second antenna structure 22 are not electrically connected. Case 3 indicates that the first antenna structure 21 and the second antenna structure 22 coexist, and the first antenna structure 21 and the second antenna structure 22 are electrically connected.

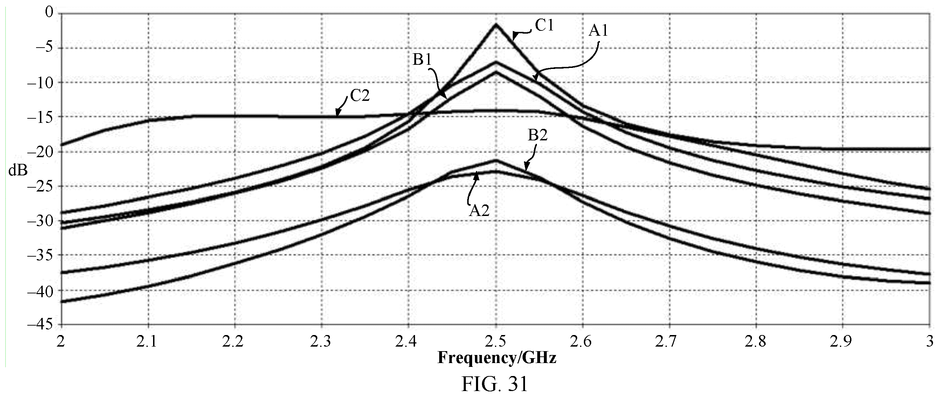

FIG. 31 is a diagram of simulation of radiation efficiency in different scenarios. A1 represents a radiation efficiency curve of Case 1 in free space, and A2 represents a radiation efficiency curve of Case 1 when the device is worn by a human body. B1 represents a radiation efficiency curve of Case 2 in free space, and B2 represents a radiation efficiency curve of Case 2 when the device is worn by a human body. C1 represents a radiation efficiency curve of Case 3 in free space, and C2 represents a radiation efficiency curve of Case 3 when the device is worn by a human body.

With reference to FIG. 31 and Table 1, it can be learned that radiation efficiency in free space in Case 3 is the highest, and is about 5 dB to 7 dB higher than those in the other two cases. A difference between radiation efficiency of Case 1 and Case 2 in free space is slight, and is about 1.5 dB. This phenomenon shows that when the first antenna structure 21, the second antenna structure 22, and the electrical connection structure 30 coexist, efficiency is significantly improved compared with that of an original scenario in which only the first antenna structure 21 exists. In other words, a structure including the second antenna structure 22 and the electrical connection structure 30 can increase an overall clearance environment of an antenna, and improve radiation efficiency of the antenna in free space. It is considered that after the device is worn by the human body, efficiency in Case 1, efficiency in Case 2, and efficiency in Case 3 all decrease, which indicates that the human body absorbs electromagnetic energy, reducing radiation efficiency of the antenna. Overall efficiency of Case 1 is lower than that of Case 2, and efficiency of Case 1 and efficiency of Case 2 are both lower than that of Case 3. Therefore, the foregoing data can indicate that when both the first antenna structure 21 and the second antenna structure 22 generate resonance, antenna efficiency can be improved. In addition, when the first antenna structure 21 is electrically connected to the second antenna structure 22, the absorption of the electromagnetic energy by the human body can be greatly reduced, and antenna efficiency can be greatly improved when the device is worn.

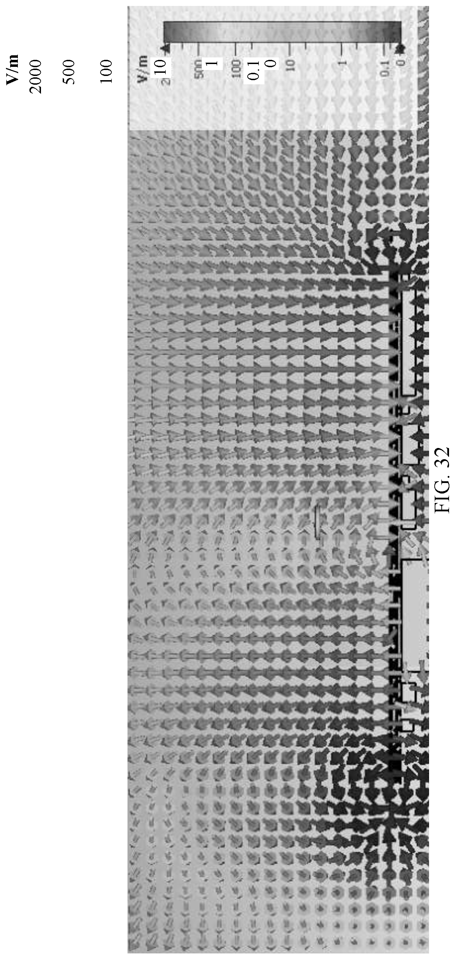

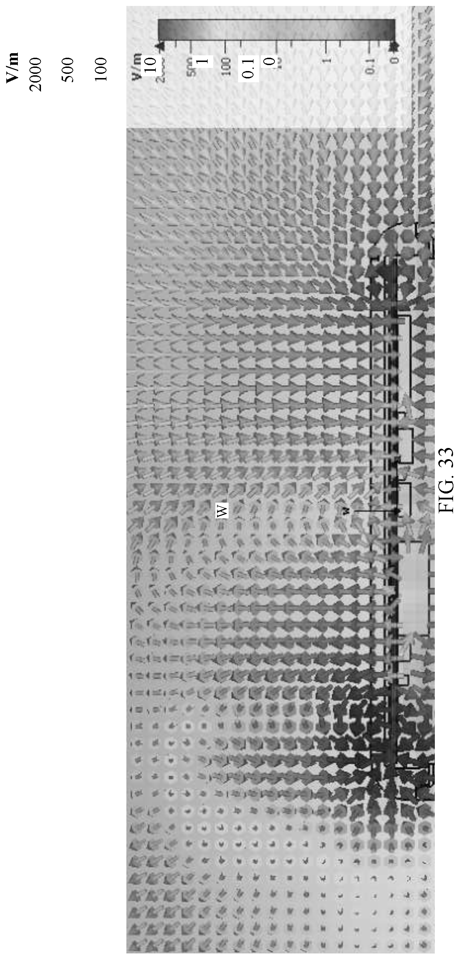

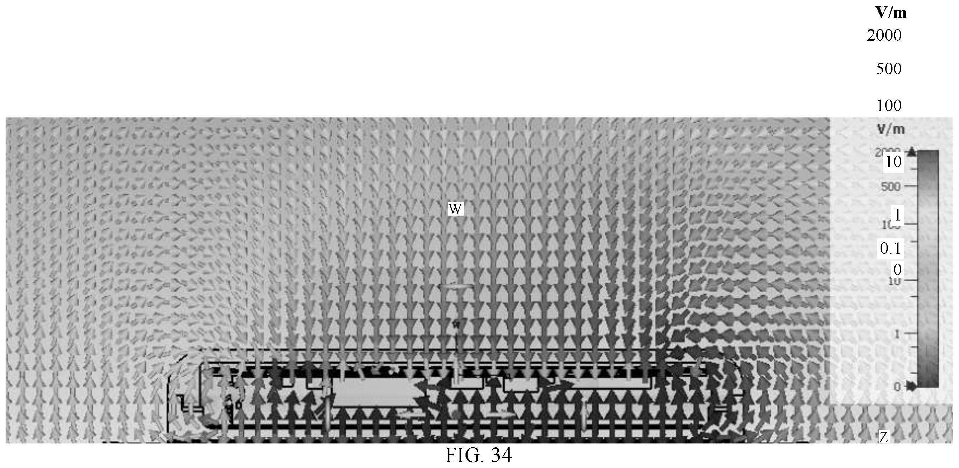

FIG. 32 is a diagram of electric field distribution in a scenario of Case 1. FIG. 33 is a diagram of electric field distribution in a scenario of Case 2. FIG. 34 is a diagram of electric field distribution in a scenario of Case 3.

Refer to FIG. 32 and FIG. 33. Electric field distribution near the human body in Case 1 and electric field distribution near the human body in Case 2 mainly include horizontal components (parallel to the human body). However, a proportion of horizontal components in Case 2 is less than a proportion of horizontal components in Case 1, so that a proportion of normal components in Case 2 is greater than a proportion of normal components in Case 1, thereby reducing absorption of electromagnetic energy by the human body and improving antenna efficiency.

Refer to FIG. 32 to FIG. 34. Electric field distribution near the human body in Case 1 and electric field distribution near the human body in Case 2 mainly include horizontal components (parallel to the human body), and electric field distribution near the human body in Case 3 mainly includes normal components (perpendicular to a surface of the human body).

It should be noted that it is difficult for a vertical component electric field (an electric field formed by normal components) to enter the human body. A higher proportion of normal components indicates fewer electric fields entering the human body. Therefore, the human body absorbs less energy, and antenna efficiency is higher. Therefore, a polarization deflection apparatus formed when all the first antenna structure 21, the second antenna structure 22, and the electrical connection structure 30 resonate may deflect some horizontal components in the electric field near the human body into normal components, so that a proportion of normal components increases. In this way, absorption of electromagnetic energy by the human body is reduced.

In the foregoing content, the first antenna structure 21 is electrically connected to the second antenna structure 22, so that the absorption of the electromagnetic energy by the human body can be greatly reduced. However, with reference to Table 1 and FIG. 33, when the first antenna structure 21 and the second antenna structure 22 coexist and are not electrically connected, the absorption of the electromagnetic energy by the human body can also be reduced. In addition, when a requirement on the thickness of the wearable electronic device 100 is not considered, the spacing between the first antenna structure 21 and the second antenna structure 22 in the thickness direction of the housing 10 may be further increased, so that the absorption of the electromagnetic energy by the human body can be further reduced, thereby improving the antenna efficiency.

In the descriptions of embodiments of this application, it should be noted that, unless otherwise clearly specified and limited, the terms such as "mounted", "connected", and "connection" should be understood in a broad sense. For example, there may be a fixed connection, may be an indirect connection through an intermediate medium, or may be an internal communication between two elements or an interaction relationship between two elements. For a person of ordinary skill in the art, specific meanings of the foregoing terms in embodiments of this application may be understood based on a specific situation.

In embodiments of this application, it is implied that an apparatus or element needs to have a specific orientation, or needs to be constructed and operated in a specific orientation, and therefore cannot be construed as a limitation on embodiments of this application. In the descriptions of embodiments of this application, unless otherwise exactly and specifically ruled, "a plurality of" means two or more.

In the specification, claims, and accompanying drawings of embodiments of this application, the terms "first", "second", "third", "fourth", and the like (if existent) are intended to distinguish between similar objects but do not necessarily describe a specific order or sequence. It should be understood that data used in such a way is interchangeable in proper circumstances, so that embodiments of this application described herein can be implemented in other orders than the order illustrated or described herein. In addition, the terms "include" and "have" and any other variants are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

The term "a plurality of" in this specification means two or more. The term "and/or" in this specification describes only an association relationship for describing associated objects and represents that three relationships may exist. For example, A and/or B may represent the following three cases: Only A exists, both A and B exist, and only B exists. In addition, the character "/" in this specification usually represents an "or" relationship between associated objects, and the character "/" in a formula usually represents a "division" relationship between associated objects.

It may be understood that various numbers in embodiments of this application are merely used for differentiation for ease of description, and are not used to limit the scope of embodiments of this application.

It should be understood that sequence numbers of the foregoing processes do not mean execution sequences in embodiments of this application. The execution sequences of the processes should be determined based on functions and internal logic of the processes, and should not be construed as any limitation on implementation processes of embodiments of this application.

## Claims

1. A wearable electronic device, comprising a housing and an antenna apparatus, wherein
the housing comprises a contact surface, and the contact surface is configured to be in contact with a wearer; and
the antenna apparatus is disposed inside the housing, the antenna apparatus comprises a first antenna structure and a second antenna structure, and both the first antenna structure and the second antenna structure are configured to generate resonance, wherein
the first antenna structure, the second antenna structure, and the contact surface are sequentially arranged in a thickness direction of the housing, and the first antenna structure and the second antenna structure are disposed at an interval; and a projection of the second antenna structure at least partially overlaps a projection of the first antenna structure in the thickness direction of the housing.

2. The wearable electronic device according to claim 1, wherein the wearable electronic device comprises an electrical connection structure, and the first antenna structure is electrically connected to the second antenna structure via the electrical connection structure.

3. The wearable electronic device according to claim 2, wherein the antenna apparatus satisfies a relational expression: L+H=kλn, wherein L is a length of the second antenna structure, H is a length of the electrical connection structure, λ is a wavelength corresponding to an operating frequency band of the antenna apparatus in free space, k is a positive integer, and n is greater than or equal to 1/4.

4. The wearable electronic device according to claim 3, wherein H is greater than or equal to a spacing between the first antenna structure and the second antenna structure in the thickness direction of the housing.

5. The wearable electronic device according to any one of claims 2 to 4, wherein the wearable electronic device comprises a floor structure, the floor structure has a first electrical connection region, the second antenna structure has a second electrical connection region, and the first electrical connection region is electrically connected to the second electrical connection region via the electrical connection structure.

6. The wearable electronic device according to claim 5, wherein a projection of the first electrical connection region at least partially overlaps a projection of the second electrical connection region in the thickness direction of the housing.

7. The wearable electronic device according to claim 6, wherein a projection of the electrical connection structure is located within an overlapping region between the projection of the first electrical connection region and the projection of the second electrical connection region.

8. The wearable electronic device according to any one of claims 5 to 7, wherein the electrical connection structure is electrically connected to a maximum current point of the floor structure.

9. The wearable electronic device according to any one of claims 2 to 8, wherein the electrical connection structure is further configured to generate resonance with both the first antenna structure and the second antenna structure.

10. The wearable electronic device according to any one of claims 2 to 9, wherein the first antenna structure and the electrical connection structure are of an integrated structure; or
the second antenna structure and the electrical connection structure are of an integrated structure; or
the first antenna structure, the second antenna structure, and the electrical connection structure are of an integrated structure.

11. The wearable electronic device according to any one of claims 1 to 10, wherein the projection of the second antenna structure comprises the projection of the first antenna structure and a projection of the floor structure in the thickness direction of the housing.

12. The wearable electronic device according to any one of claims 1 to 10, wherein the projection of the second antenna structure comprises the projection of the first antenna structure in the thickness direction of the housing.

13. The wearable electronic device according to any one of claims 1 to 12, wherein the second antenna structure is a closed ring structure, or the second antenna structure is a stub structure.

14. The wearable electronic device according to any one of claims 1 to 13, wherein the first antenna structure comprises a feed point.

15. The wearable electronic device according to any one of claims 1 to 14, wherein the wearable electronic device comprises a printed circuit board, and the printed circuit board comprises the first antenna structure.

16. The wearable electronic device according to any one of claims 1 to 14, wherein the wearable electronic device comprises a circuit board assembly, and the circuit board assembly comprises a first circuit board and a second circuit board that are electrically connected, wherein
the first circuit board comprises the first antenna structure, and the second circuit board comprises the second antenna structure; or
the first circuit board comprises the first antenna structure, and the first circuit board, the second circuit board, and the second antenna structure are sequentially arranged at an interval in the thickness direction of the housing.

17. The wearable electronic device according to any one of claims 1 to 16, wherein the first antenna structure is one of the following antennas: an inverted F antenna, a monopole antenna, a loop antenna, and a planar inverted F antenna.
